# EUROPEAN PATENT APPLICATION

(11) **EP 1 101 835 A1**
(43) Date of publication of application: **23.05.2001**
(21) Application number: 00310184.7
(22) Date of filing: 16.11.2000
(51) Int. Cl.: C23C 14/35, H01J 37/34

(54) **Method and apparatus for physical vapor deposition using modulated power**

(30) Priority: 16.11.1999 US 441032
(71) Applicant: Applied Materials, Inc., Santa Clara, California 95054 (US)
(72) Inventor: Chiang, Tony P., San Jose, California 95117 (US); Ding, Peijun, San Jose, California 95129 (US); Chin, Barry, Saratoga, California 95070 (US)
(74) Representative: Bayliss, Geoffrey Cyril

(57) **Abstract**

The disclosure relates to a method and apparatus for achieving conformal step coverage on a substrate by ionized metal plasma deposition. A target (104) provides a source of material to be sputtered and ionized by a plasma maintained by a coil (122). The ionized material is deposited on the substrate that is biased to a negative voltage. A power supply (130) coupled to the target supplies a modulated or time-varying signal thereto during processing. Preferably, the modulated signal includes a negative voltage portion and a positive voltage portion. The negative voltage portion and the positive voltage portion are alternated to cycle between a center-strong sputter step and an edge-strong sputter step. The film quality and uniformity can be controlled by adjusting the frequency and amplitude of the signal, the duration of the positive portion of the signal, the power supplied to each of the support member and the coil, and other process parameters.

## Description

The present invention relates to an apparatus and method for processing substrates. Specifically, the invention relates to a method for depositing a conformal layer of material on a substrate using an ionized metal plasma process.

Sub-quarter micron multi-level metallization represents one of the key technologies for the next generation of ultra large-scale integration (ULSI) for integrated circuits (IC). In the fabrication of semiconductor and other electronic devices, directionality of particles being deposited on a substrate is important to improve adequate filling of electric features. As circuit densities increase, the widths of vias, contacts and other features, as well as the dielectric materials between them, decrease to 0.18 µm or less, while the thickness of the dielectric layer remains substantially constant. Thus, the aspect ratio for the features, *i.e.*, the ratio of the depth to the minimum lateral dimension, increases, thereby pushing the aspect ratios of the contacts and vias to 5:1 and above. As the dimensions of the features decrease, it becomes desirable to obtain deposition uniformity and conformal step coverage on substrate as well as achieve acceptable particle performance.

To obtain deposition in the high aspect ratio (HAR) features, one method uses a medium/high pressure physical vapor deposition (PVD) process known as an ionized metal plasma (IMP) process or high-density plasma physical vapor deposition (HDP-PVD). The plasma density in such high density plasma processes is typically between about 10¹¹ cm⁻³ and 10¹² cm⁻³. Generally, IMP processing offers the benefit of highly directional deposition with good bottom coverage in HAR features. High density plasma sputtering processes have been successfully implemented for obtaining conformal coverage for titanium (Ti), titanium nitride (TiN), tantalum (Ta), tantalum nitride (TaN), copper (Cu), tungsten (W), and tungsten nitride (WN). In one high density plasma deposition configuration, a typical chamber includes a coil, or other electromagnetic field generating device, for maintaining a high density, inductively-coupled plasma between a target and a susceptor on which a substrate is placed for processing. Initially, a plasma is generated by introducing a gas, such as helium or argon, into the chamber and then coupling energy into the chamber via the target to ionize the gas. The coil is positioned proximate to the processing region of the chamber and produces an electromagnetic field that induces currents in the plasma resulting in an inductively-coupled medium/high density plasma between the target and the susceptor. The ions and electrons in the plasma are accelerated toward the target by the negative bias applied to the target causing the sputtering of material from the target. At least a portion of the sputtered metal flux is then ionized by interaction with the plasma. An electric field due to an applied or self-bias, develops in the boundary layer, or sheath, between the plasma and the substrate and electrically attracts and accelerates the metal ions towards the substrate in a direction parallel to the electric field and perpendicular to the substrate surface. The bias energy is preferably controlled by the application of power, such as RF or DC power, to the susceptor to attract the sputtered target ions in a highly directionalized manner to the surface of the substrate to fill the features formed on the substrate.

One difficulty with IMP processes is producing uniform film thickness over the entire substrate. In practice, the resulting film in IMP processes exhibit a greater thickness toward the center of the substrate. Center-thick films are undesirable because the increasingly smaller features of devices require good thickness uniformity to produce reliable devices.

Therefore, there is a need for a method of depositing materials on a substrate in an inductively-coupled plasma environment wherein the resulting layers exhibit good uniformity and step coverage.

The present invention generally provides an apparatus and method for depositing a conformal layer on a substrate in a plasma chamber using a high density plasma. In one aspect of the invention, a chamber having a target, a first power supply coupled to the target, a substrate support member, a second power supply connected to the substrate support member, and a coil to generate an electromagnetic field is provided. The target comprises a material to be sputtered by a plasma formed adjacent to the target during processing. A time-varied signal supplied by the first power supply preferably comprises a negative voltage portion and a positive voltage portion. Preferably, the second power supply connected to the substrate support member supplies a substantially constant negative bias to the substrate. A power supply is also connected to the coil, which is also sputtered during deposition.

In another aspect of the invention, a plasma is formed in or supplied to a chamber to sputter a material from a target. A coil is energized in the chamber to enhance ionization of the sputtered material. During processing, a signal having a desired waveform is provided to the target. In one embodiment, the signal is varied between a negative voltage portion during which the target material is sputtered onto a substrate and a small positive voltage portion during which the coil alone is sputtered. A bias is provided to the substrate to influence the direction of ions in the chamber during processing.

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

Figure 1 is a cross-section of a simplified processing chamber having a coil disposed therein.

Figure 2 is a graphical illustration of a signal applied to a target.

Figure 3 is a graphical illustration of a signal applied to a substrate.

The embodiments described below are implemented using an ionized metal plasma (IMP) process that can be carried out using process equipment, such as an ion metal plasma (IMP) processing chamber, known as an IMP ELECTRA^{TM} Chamber mounted on an Endura® platform, both of which are available from Applied Materials, Inc., located in Santa Clara, California . The equipment can include an integrated platform having a preclean chamber, an IMP-PVD barrier layer chamber, a PVD chamber, an IMP-PVD seed layer chamber, and a CVD chamber.

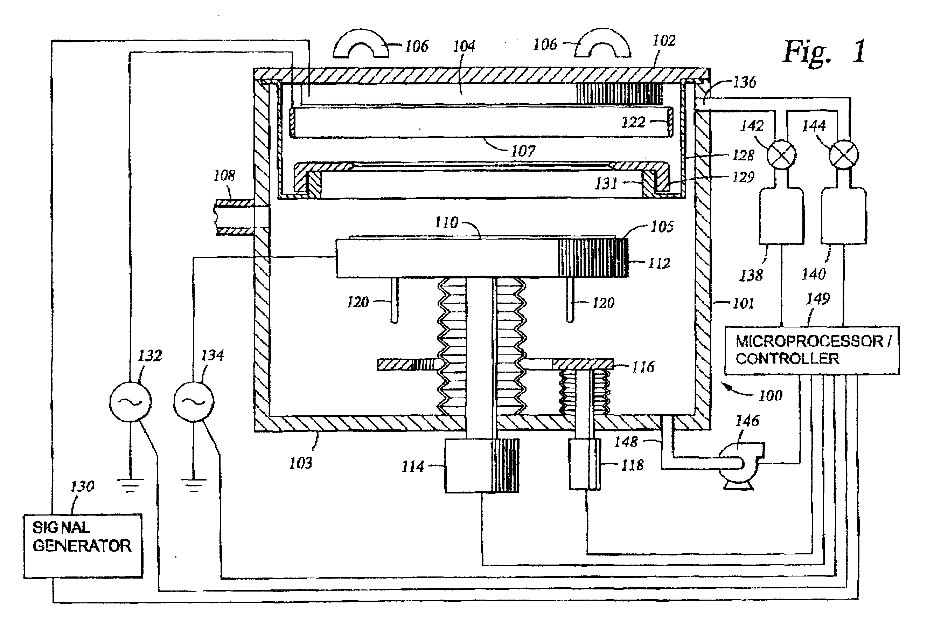

Figure 1 is a schematic cross-sectional view of an IMP chamber 100 according to the present invention. The chamber 100 includes walls 101, lid 102, and bottom 103. A target 104 comprising the material to be sputtered is mounted to the lid 102 and disposed in the chamber 100 to define an upper boundary to a processing region 107. Magnets 106 are disposed behind the lid 102 and are part of a rotatable magnetron that provides for magnetic field lines across the face of the target about which free electrons in the plasma spiral, and thus increase the density of a plasma adjacent to the target 104.

A substrate support member 112 supports the substrate 110 and defines the lower boundary to the processing region 107. The substrate support member 112 is movably disposed in the chamber 100 and provides an upper support surface 105 for supporting a substrate 110. The support member 112 is mounted on a stem 109 connected to a motor assembly 114 that raises and lowers the substrate support 112 between a lowered loading/unloading position and a raised processing position. An opening 108 in the chamber 100 provides access for a robot (not shown) to deliver and retrieve substrates 110 to and from the chamber 100 while the substrate support member 112 is in the lowered loading/unloading position.

A coil 122 is mounted in the chamber 100 between the substrate support member 112 and the target 105 and when energized by an AC power source provides electromagnetic fields in the chamber 100 during processing to assist in generating and maintaining a plasma between the target 104 and substrate 110. The electromagnetic fields produced by the coil 122 induce currents in the plasma to densify the plasma which, in turn, ionizes at least a portion of the sputtered target material flux. At least a portion of the positively charged ionized material is then attracted toward the negatively biased substrate 11 Oand deposits thereon. The coil 122 is made of a similar materials as the target and is also sputtered during processing.

The chamber 100 optionally includes a process kit comprising a process shield 128 and a shadow ring 129. The process shield 128 is an annular member suspended from the lid 102 between the coil 122 and the body 101. An upwardly turned wall 131 of the process shield 128 is adapted to support the shadow ring 129 while the support member 112 is in a lowered position. The process shield is preferably coupled to ground to provide a return path for RF currents in the chamber 100.

One or more plasma gases are supplied to the chamber 100 through a gas inlet 136 from gas sources 138, 140 as metered by respective mass flow controllers 142, 144. One or more vacuum pumps 146 are connected to the chamber 100 at an exhaust port 148 to exhaust the chamber 100 and maintain the desired pressure in the chamber 100. Preferably the vacuum pumps 146 include a cryopump and a roughing pump and are capable of sustaining a base pressure of about 10⁻⁸mTorr.

Three power supplies are used in the chamber 100. A first power supply 130 delivers modulated or time-varied power to the target 104 to generate a plasma of the one or more plasma gases. By modulated or time-varied is meant that the voltage applied to the target varies with time, preferably on a periodic basis. The power supply 130 is adapted to vary at least the magnitude of the applied voltage to the target 104 and preferably is capable of changing the charge, *i.e.,* negative and positive. Preferably, the first power supply 130 is a modulated direct current (DC) power supply capable of providing a modulated signal to the target 104. However, the particular arrangement used to provide a modulated signal is not limiting of the present invention and may include any conventional components known in the art, such as switches, pulse generators, microprocessors and the like. A second power source 132, preferably a RF power source, supplies electrical power in the megahertz range to the coil 122 to control the density of the plasma. A third power source 134, preferably a RF or a DC power source, biases the substrate support member 112 with respect to the plasma and provides an electric field adjacent a substrate to attract the ionized sputtered material toward the substrate 110.

In operation, a robot delivers a substrate 110 to the chamber 100 through the opening 108. After depositing the substrate 110 unto the upper surface 105 of the support member 112 the robot retracts from the chamber 100 and the opening 108 is sealed. The substrate support member 112 then raises the substrate 110 into a processing position. During the upward movement of the support member 112 the shadow ring 129 is lifted from the process shield 128. During processing, the shadow ring 129 covers a perimeter portion (usually less than 3 millimeters) of the substrate 110. Preferably, the space between the target 104 and the substrate support member 112 in a raised processing position is between about 100 mm and 190 mm preferably 130 mm - 140 mm.

One or more gases are then introduced into the chamber 100 from the gas sources 138, 140 to stabilize the chamber 100 at a processing pressure. A high negative voltage is then imposed on the target 104 from its power supply 130, to strike a plasma in the chamber 100. The coil power supply 132 is also activated to pass an RF signal through the coil 122, which creates inductive coupling with the plasma region. The coil 122 will quickly establish a negative selfbias, which also causes sputtering of the coil surface.

The coil 122 operates to induce electrical currents in the plasma between the target 104 and substrate 110 to create a more dense plasma, thereby enhancing the ionization of the sputtered material from the target 104 and the coil 122 which occurs as a result of interaction with the plasma ions. A portion of the ions formed from the sputtered material traverse the space between the processing region 107 and deposit on the substrate 110 which is biased by the third power supply 134. The biases to the target 104 and support member 112 are controlled according to the processes described in detail below.

Following the deposition cycle, the substrate support member 112 is lowered to a loading/unloading position. The robot is then extended into the chamber 100 through the opening 108 and the substrate 110 is received on the robot for removal from the chamber 100 and delivery to a subsequent location. Subsequent locations include various processing chambers, such as electroplating chambers, where the substrate 110 undergoes additional processing.

The present invention controls the rate of deposition at the center and edge portions of the substrate to affect overall film uniformity. By modulating the RF coil/DC target power ratio over a well-controlled time scale, an increase in film uniformity across the surface of the substrate can be achieved. The proportions of coverage are controlled by adjusting the application of the waveform applied to the target 104.

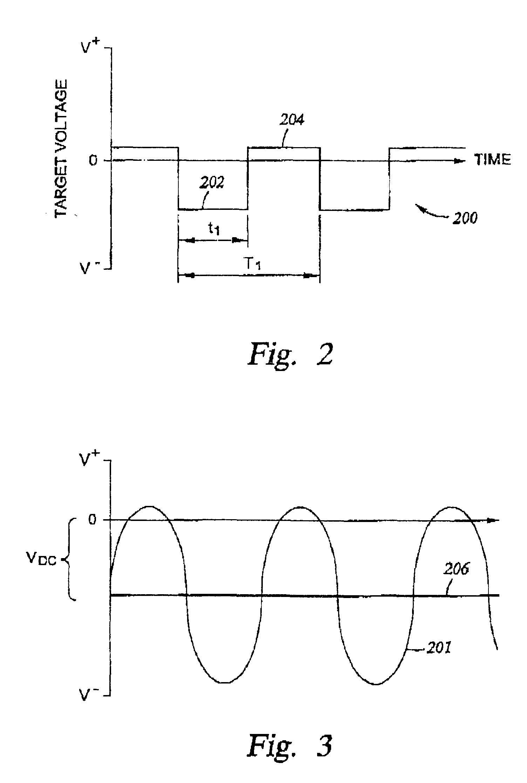

During the deposition process, the power supply 130 delivers a modulated signal to the target 104. The signal 200, shown in Figure 2, includes a negative voltage portion 202 and a positive voltage portion 204. Although shown here as a square wave, any waveform oscillated between a negative voltage portion and a positive voltage portion may be used to advantage. Additionally, in another embodiment, the signal 200 is modulated between two negative voltages or between a negative voltage and no voltage (no signal).

During the negative voltage portion 202, the positively charged ions supplied by the plasma gas, such as Ar, bombard the target 104 causing ejection of material therefrom. The energy of the Ar ions can be controlled by adjusting the bias to the target 104. Preferably, the power supplied to the target 104 is sufficient to induce a negative voltage portion 202 between about -100V and about -300V, with increasing voltage resulting in increased sputtering from the target 104. The resulting metal flux is then ionized under the influence of the plasma and deposits on the substrate 110. During the negative voltage portion 202 of the signal 200, the bulk of the material being deposited on the substrate 110 is produced by the target 104, as opposed to the coil 122. As a result, the deposited film exhibits a center-thick profile.

During the subsequent positive voltage portion 204 of the signal 200, sputtering from the target 104 is minimized or even terminated and sputtering from the coil 122 dominates the resulting deposition onto the substrate 110. Deposition will therefore occur primarily at the edge of the substrate. It is believed that by providing increased deposition at the substrate edge for a predetermined period of time, better film uniformity will be obtained. Preferably, the positive voltage portion 204 is between about 0V and +50V. Additionally, during the positive portion 204 the electron temperature of the plasma is increased because the total flux of material is less than during the negative voltage portion. Accordingly, the plasma is able to ionize more of the sputtered material.

The negative voltage portion 202 and the positive-voltage portion 204 are sequentially alternated to result in a series of target/coil sputtering steps (or center strong deposition steps), and coil sputtering steps (or substrate deposition steps). The frequency and duty cycle of the signal 200 can be adjusted to control the target/coil and coil sputtering steps to achieve the desired results. Preferably, the frequency of the signal 200 is between about 1kHz and 200kHz. As defined herein, the duty cycle is the ratio of the pulse width, tl, of the negative voltage portion 202 to the signal period T1, shown in Figure 3. Preferably, the duty cycle is between about 50% and about 90% with a pulse width t1 between about 1:s and lms.

Although the voltage applied to the substrate 110 may be modulated in a manner similar to the signal 200 provided to the target 104, preferably the voltage is maintained at a substantially constant value throughout a deposition cycle. Accordingly, a voltage drop is continuously maintained across a region between the plasma and the substrate 110 known as the sheath or dark space. Due to the resulting voltage drop in the sheath, an electric field is generated substantially perpendicular to the substrate 110, thereby causing the ions to accelerate toward the substrate. Figure 3 shows an RF signal 201 provided to the substrate 110 by the third power supply 134. In the presence of a plasma, the signal 201 is shifted downward into the negative voltage region resulting in an induced DC bias (Vdc) on the substrate 110. The Vdc, shown in Figure 3 as a signal 206, is maintained at a substantially constant value. In one embodiment, the power from the third power supply 134 is sufficient to produce an applied bias on the substrate 110 between about 0V and -300V. The particular values for power and voltage may be adjusted to achieve the desired result.

The modulation of the target bias with periodic positive pulses has resulted in various additional findings. For example, it was discovered that in another embodiment of the process, modulation of the applied DC voltage to the target with waveform 200 minimized or prevents deleterious target conditions. One such condition is known as target poisoning. Target poisoning occurs during reactive sputtering when the reactive species saturates the surface of the target. Sputtering of a poisoned target produces an unusable film. For example, in TaN and WN deposition, the resulting film exhibits significantly increased resistivity. Another undesirable target condition, is the formation of nodules on the target surface which can occur during reactive sputtering. The nodules are buildup of dielectric material that occurs as a result of the interaction between the target materials and the gases in the chamber. Over time, the nodules can result in micro-arching and other deleterious effects capable of damaging substrates.

The present invention mitigates the problems of target poisoning and nodule formation by reverse biasing the target periodically. The positive pulse is believed to "clean" the surface of the target by discharging the charged particles that adhere to the surface and ultimately result in target poisoning and nodule formation if left undisturbed for a sufficient period of time.

While the foregoing is directed to the preferred embodiment of the present invention, other and further embodiments of the invention may be devised without departing from the basic scope thereof, and the scope thereof is determined by the claims that follow.

## Claims

1. A method of depositing a material on a substrate, comprising:
(a) providing a plasma in a processing chamber having a coil and a target disposed therein;
(b) biasing the substrate with a negative voltage;
(c) applying a bias to the target and the coil for a first period of time; and
(d) applying a bias to the coil for a second period of time.

2. A method as claimed in claim 1, wherein sputtering the coil comprises supplying a radio frequency (RF) signal to the coil.

3. A method as claimed in claim 1, wherein sputtering the target comprises supplying a direct current (DC) to the target

4. A method as claimed in claim 1 or claim 2, wherein the first period of time is between about 1:s and 1ms second and the second period of time is about 1:s and 1ms.

5. A method as claimed in any of claims 1 to 4, wherein the first voltage negative and the second voltage is positive.

6. A method as claimed in any of claims 1 to 5, wherein (c) and (d) comprise providing a signal to the target having a frequency of between about 1kHz and 200kHz.

7. A method as claimed in any of claims 1 to 6, wherein (c) and (d) comprise providing a signal to the target having a duty cycle of between about 50% and about 90%.

8. A method as claimed in any of claims 1 to 7, wherein (c) comprises providing a signal to the target and coil and (d) comprises providing a signal only to the coil.

9. A method of depositing a material on a substrate, comprising:
(a) supplying a gas to a processing chamber;
(b) biasing the substrate with a negative voltage;
(c) energizing a coil in the chamber; and
(d) biasing the target with a signal having at least a first voltage and a second voltage having an absolute value less than an absolute value of the first voltage.

10. A method as claimed in claim 9, wherein the signal is adapted to provide relatively more deposition on a first region of the substrate during application of the first voltage and relatively more deposition on a second region of the substrate diametrically exterior to the first region during application of the second voltage.

11. A method as claimed in claim 9 or claim 10, wherein energizing the coil comprises supplying a radio frequency (RF) signal to the coil.

12. A method as claimed in any of claims 9 to 11, wherein the signal is a direct current (DC) signal.

13. A method as claimed in any of claims 9 to 12, wherein the first voltage is negative and the second voltage is positive.

14. A method as claimed in any of claims 9 to 12, wherein the first voltage and the second voltage are negative.

15. A method as claimed in any of claims 9 to 12, wherein the first voltage is negative and the second voltage is zero.

16. A method as claimed in any of claims 9 to 12, wherein the first voltage is between about -100V and about -300V.

17. A method as claimed in any of claims 9 to 11, wherein the signal has a frequency of between about 1kHz and 200kHz.

18. A method as claimed in any of claims 9 to 11, wherein the signal has a duty cycle of between about 50% and about 90%.

19. A method of depositing a material on a substrate in a process chamber, wherein the substrate includes a feature formed therein, comprising:
(a) providing a plasma in the process chamber having a coil and a target disposed therein;
(b) biasing the substrate with a negative voltage; and
(c) alternating between a target/coil sputtering step and a coil sputtering step, wherein the target/coil sputtering step comprises applying a bias to a target and the coil and the coil sputtering step comprises applying a bias to the coil.

20. A method as claimed in claim 19, wherein applying the bias to the coil comprises supplying a radio frequency (RF) signal to the coil.

21. A method as claimed in claim 19 or claim 20, wherein applying the bias to the coil comprises supplying a radio frequency (RF) signal to the coil at a power between about 1 kW and 5 kW.

22. A method as claimed in claim 19, wherein applying the bias to the target comprises applying a voltage between about -300 V and about +50V.

23. A method as claimed in claim 19, wherein applying the bias to the target comprises applying a first voltage to the target during the coil sputtering step having an absolute value less than an absolute value of a second voltage applied to the target during the target/coil sputtering step.

24. A method as claimed in claim 19 or claim 20, wherein applying the bias to the target comprises applying a signal to the target at a frequency of between about 1 kHz and 200 kHz.

25. A method as claimed in claim 24, wherein the signal has a duty cycle of between about 50% and about 90%.

26. An apparatus, comprising:
(a) a processing chamber;
(b) a target disposed in the chamber;
(c) a substrate support member disposed in the chamber and having a support surface in facing relation to the target;
(d) a coil disposed in the processing chamber to provide an electromagnetic field therein;
(e) a power source coupled to the target to provide a time-varying power signal to the target during processing; and
(f) an RF power source coupled to the coil.

27. A apparatus as claimed in claim 26, wherein the power source is a DC power source adapted to provide the time-varying power signal.

28. A apparatus as claimed in claim 26 or claim 27, wherein the power source is a DC power source adapted to provide the time-varying power signal at between -300V and +50V.

29. A apparatus as claimed in any of claims 26 to claim 28, wherein the target and coil are comprised of a material selected from the group comprising Ti, Cu, Ta, W, Al and any combinations thereof.

30. A apparatus as claimed in any of claims 26 to 29, further comprising a gas source coupled to the processing chamber to supply a gas for generating a plasma in the processing region during processing.

31. A apparatus as claimed in any of claims 26 to 30, further comprising a microprocessor controller that is connected to the processing system and is adapted to control the various components of the system including at least valves, robots, mass flow controllers and power supplies.
